# EUROPEAN PATENT APPLICATION

(11) **EP 2 608 264 A1**
(43) Date of publication of application: **26.06.2013**
(21) Application number: 12199358.8
(22) Date of filing: 24.12.2012
(51) Int. Cl.: H01L 29/66

(54) **Method for manufacturing a field-effect semiconductor device following a replacement gate process**

(30) Priority: 23.12.2011 EP 11195617
(71) Applicant: IMEC, 3001 Leuven (BE); Katholieke Universiteit Leuven, 3000 Leuven (BE)
(72) Inventor: Witters, Liesbeth, B-3001 Leuven (BE); Mitard, Jerome, B-3001 Leuven (BE); Hellings, Geert, B-3001 Leuven (BE)
(74) Representative: Sarlet, Steven Renaat Irène

(57) **Abstract**

The invention relates to a method for manufacturing a field-effect semiconductor device (1), the method comprising: forming a temporary dummy gate (DG) over a substrate layer (SL); forming temporary first gate insulating spacers (S11, S12) adjacent to the sidewalls of said dummy gate (DG) and over the substrate layer (SL), the temporary first gate insulating spacers comprising two lateral side walls (SW1, SW2) and presenting two outer surface profiles (SP1, SP2) where said lateral side walls meet said substrate layer (SL); forming a source region (S) and a drain region (D) in and/or over the substrate layer (SL) using said temporary first gate insulating spacers lateral side walls surface profiles (SP1, SP2); forming second gate insulating spacers (S21, S22) adjacent to the sidewalls of the temporary first gate insulating spacers (S11, S12) and over the source and drain regions (S, D); removing the temporary dummy gate (DG) and the temporary first gate insulating spacers (S11, S12), thereby forming a first gate recess space (RS1); depositing a dielectric layer (DL) in said first gate recess space (RS1), along the side walls of the second gate sidewall insulating spacers (S21, S22) and over the substrate layer (SL), thereby forming a second gate recess space (RS2); and depositing a gate electrode (GE) in the second gate recess space (RS2).

The invention also relates to a field-effect semiconductor device and associated products, e.g. integrated or electronic circuits comprising one or a plurality of said FET devices manufactured according to the method described herein.

## Description

### Technical Field

The present invention relates generally to field-effect semiconductor devices, such as field-effect transistors (FETs), and more specifically to a method for manufacturing a field effect semiconductor device following a replacement gate process.

### Background of the invention

Several challenges still remain for large scale integration of field-effect semiconductor devices. As FET transistor gate lengths continue to scale down, the offset spacer design becomes critical for transistor performance. The required dimensions of such dielectric offset spacers, also referred to as sidewall spacers, are increasingly smaller and the processes to define the offset spacer profile are increasingly difficult to control in order to achieve the desired critical dimensions.

Therefore there is a need to address the heightened sensitivity to gate spacer dimensioning using process techniques for gate sidewall spacer formation, particularly in manufacturing processes following a gate-last approach, also called replacement gate or damascene gate processes.

US patent application, for example, 2007/0287259 A1 discloses the use of gate isolation spacers in a method of forming a semiconductor structure according to a replacement gate process.

Also, in US patent application 2006/0148182 A1, a self-aligned source drain quantum well transistor or high electron mobility transistor is formed using a replacement metal gate process, in which sidewall spacers temporarily bracket a dummy gate electrode.

A problem with the current techniques for manufacturing FET devices is that they lack a precise control of the distance from the source/drain extensions to the gate edge.

### Summary of the invention

It is the object of the present invention to provide an improved FET device and method for manufacturing the same, using a replacement gate process, which overcomes current FET design source/drain extension underlap and overlap drawbacks.

According to one aspect of the present invention, a method for manufacturing a field-effect semiconductor device is provided, the method comprising: forming a temporary dummy gate over a substrate layer; forming temporary first gate insulating spacers adjacent to the sidewalls of said dummy gate and over the substrate layer, the temporary first gate insulating spacers comprising two lateral side walls and presenting two outer surface profiles where said lateral side walls meet said substrate layer; forming a source region and a drain region in and/or over the substrate layer using said temporary first gate insulating spacers lateral side walls surface profiles; forming second gate insulating spacers adjacent to the sidewalls of said temporary first gate insulating spacers and over the source and drain regions; removing the temporary dummy gate and the temporary first gate insulating spacers, thereby forming a first gate recess space; depositing a dielectric layer in said first gate recess space, directly along the side walls of the second gate sidewall insulating spacers and over the substrate layer, thereby forming a second gate recess space; and depositing a gate electrode in said second gate recess space.

Advantageously field-effect semiconductor devices manufactured according to the invention avoid sensitivity to offset spacer critical dimension and present reduced sensitivity towards S/D-gate overlap/underlap variations, which greatly impact the transistor performance.

Advantageously, the method for manufacturing a field-effect semiconductor device according to the invention allows better control and design of the device performance characteristics (e.g. resistance, capacitance and gate-drain leakage) by providing a mechanism to increase precision control for defining the source and drain region distance to the gate electrode edges, e.g. for both overlap and underlap field-effect semiconductor device design. In that sense, the method according to the invention advantageously allows better repeatability of the field-effect semiconductor device performance characteristics.

The method according to the invention can be advantageously applied for manufacturing both planar devices, such as, for example, implant-free quantum well (IFQW) FET devices or silicon on oxide (SOI) pFET devices, and non-planar FET devices such as, for example, FinFET devices. Advantageously, in case of non-planar devices, the S/D-gate overlap/underlap distance along the FIN walls is more precisely controlled, and for example, a fixed external resistance (Rext) along the FIN walls is achieved.

According to another aspect of the invention the step of forming the source and drain region comprises using the surface profiles of the temporary first gate insulating spacers lateral side walls to align the source/drain regions, in or over the substrate layer, to those surface profiles.

According to still another aspect of the invention, the step of forming the source and drain region comprises using the surface profiles of the temporary first gate insulating spacers lateral side walls to define said source/drain region extension, in the substrate layer, under the dummy gate.

Advantageously, according to the invention, the surface profile of the temporary first gate insulating spacers lateral side walls is set and used as a reference point to align the source/drain regions over the substrate layer, e.g. by epitaxial overgrowth of the source/drain regions, or as a mask to align the source/drain regions in the substrate layer, or to define the source/drain region extension in the substrate under the dummy gate by, for example, first etching the substrate layer starting from the surface profile of said temporary first gate insulating spacers lateral side walls and then filling said etched openings to form the source/drain regions.

According to still another aspect of the invention, the step of forming the source and drain region comprises using said surface profiles of said temporary first gate insulating spacers lateral side walls to align said source/drain regions, over the substrate layer, to said surface profiles and to define said source/drain region extension, in the substrate layer, under the dummy gate.

According to one embodiment of the invention, the temporary first gate insulating spacers are removed after the temporary dummy gate removal, thereby forming a first gate recess space.

According to another embodiment of the invention, the method comprises forming a temporary dummy dielectric between the dummy gate and the substrate layer, and the step of removing the temporary dummy gate and the temporary first gate insulating spacers comprises also removing the dummy dielectric, thereby forming the first gate recess space.

According to one embodiment of the invention, the step of removing the temporary first gate insulating spacers comprises selectively removing the material of the temporary first gate insulating spacers without substantially removing the material of the second gate insulating spacers, for example by etching out the material of the temporary first gate insulating spacers without substantially removing the material of the second gate insulating spacers, e.g. with a selectivity ratio higher than 2 to 1. In one example, the temporary first gate insulating spacers are made of an oxide material and the second gate insulating spacers are made of a dense nitride material. In another example, the temporary first gate insulating spacers are made of a nitride component deposited at temperatures lower than 480 C and designed to etch faster in hydrofluoric acid than the material of the second gate insulating spacers.

According to another embodiment of the invention, the substrate layer comprises at least one silicon wafer layer, at least a silicon wafer layer and a quantum well layer, or at least a silicon wafer layer, a buried oxide layer and a silicon layer.

The invention also relates to field-effect semiconductor devices and associated devices, e.g. integrated or electronic circuits comprising one or a plurality of said FET devices manufactured according to the method described herein.

Certain objects and advantages of various inventive aspects have been described above. It is to be understood that not necessarily all such objects or advantages may be achieved in accordance with any particular embodiment of the invention. Those skilled in the art will recognize that the invention may be embodied or carried out in a manner that achieves or optimizes one advantage or group of advantages without necessarily achieving other objects or advantages as may be taught or suggested herein.

### Brief description of the drawings

The above and other aspects of the invention will be apparent from the following description and with reference to the non-restrictive example embodiment(s) described hereinafter.
**Figure 1A** is a cross-sectional view of one embodiment of the invention at an early stage of manufacture.
**Figure 1B** is a top view of the embodiment shown in **figure 1A****.**
**Figure 2** is a cross-sectional view of the embodiment shown in **figure 1A** in a subsequent step of manufacture in accordance with the invention.
**Figure 3** is a cross-sectional view of the embodiment shown in **figure 2** in a subsequent step of manufacture in accordance with the invention.
**Figure 4** is a cross-sectional view of one embodiment of a field-effect semiconductor device according to the invention after completion of the gate stack stage of manufacture comprising the manufacturing steps shown in **figures 1 to 3****.**
**Figure 5** is a cross-sectional view of another embodiment of the invention at an early stage of manufacture.
**Figure 6** is a cross-sectional view of one embodiment of a field-effect semiconductor device according to the invention after completion of the gate stack stage of manufacture comprising the manufacturing step of **figure 5****.**
**Figure 7** is a cross-sectional view of still another embodiment of the invention at an early stage of manufacture.
**Figure 8** is a cross-sectional view of the embodiment shown in **figure 7** in a subsequent step of manufacture in accordance with the invention.
**Figure 9** is a cross-sectional view of the embodiment shown in **figure 8** in a subsequent step of manufacture in accordance with the invention.
**Figure 10** is a cross-sectional view of the embodiment shown in **figure 9** in a subsequent step of manufacture in accordance with the invention.
**Figure 11** is a cross-sectional view of one embodiment of a field-effect semiconductor device according to the invention after completion of the gate stack stage of manufacture comprising the manufacturing steps shown in **figures 7 to 10****.**
**Figure 12** is a cross-sectional view of one embodiment of a field-effect semiconductor device according to the invention after completion of the gate stack stage of manufacture.
**Figure 13** is a schematic 3D view of a non-planar field-effect semiconductor device at an early stage of manufacture according to an exemplary embodiment of invention.

### Detailed description

In the following, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This is however not to be interpreted as the invention requiring more features than the ones expressly recited in each claim, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those skilled in the art. In the description of the embodiments, numerous specific details are set forth.

However, it is understood that embodiments of the invention may be practiced without these non-essential specific details. In other instances, well-known methods, structures and techniques have not been shown in detail in order not to obscure an understanding of this description.

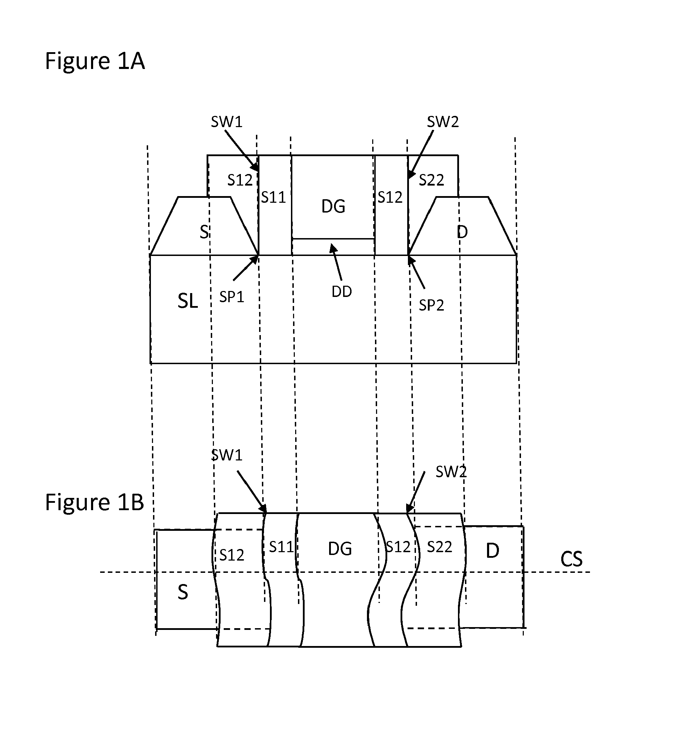

**Figure 1A** is a cross-sectional view, across line CS of **figure 1B**, of one embodiment of the invention at an early stage of manufacture, comprising a substrate layer SL, a source region S and a drain region D, a dummy gate DG, a dummy dielectric DD, a first pair of gate insulating spacers S11 and S12 presenting two lateral side walls SW1 and SW2 in the length direction of the field-effect semiconductor device channel and two outer surface profiles SP1 and SP2 where the lateral side walls meet the substrate layer SL, and a pair of second gate insulating spacers S21 and S22.

The first gate insulating spacers can be also called first offset spacer or first sacrificial spacers, and are sacrificial spacers laid along the walls of the dummy gate. It shall also be understood that, in the following embodiments, the elements of the figures are shown schematically and for illustration purposes only and therefore the real geometry of those elements may vary when implemented.

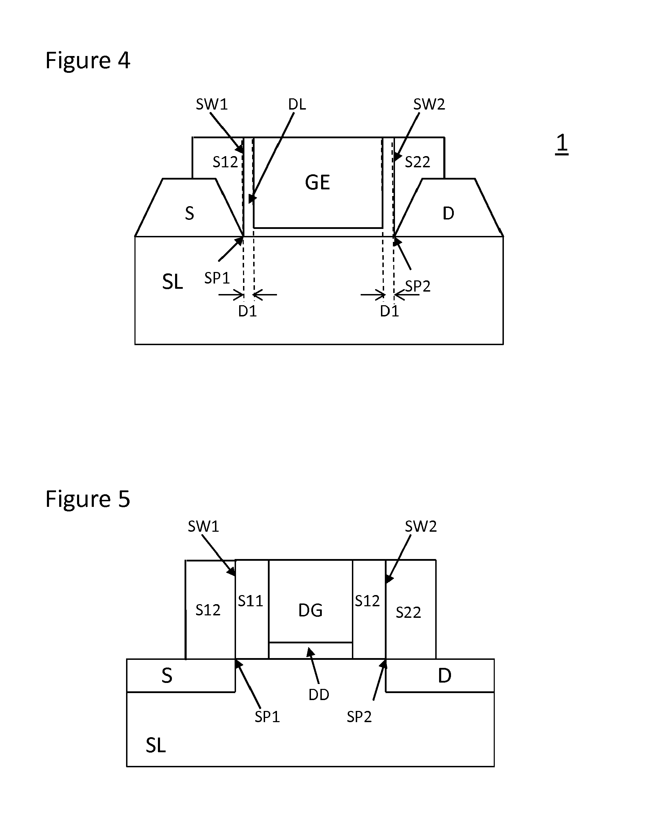

Manufacturing of the field-effect semiconductor device 1 of **figure 4** may begin by forming the embodiment of **figures 1A** and **1B** according to the following: in a first step a temporary dummy dielectric DD and a temporary dummy gate DG are formed over a substrate layer SL; in a second step, a pair of temporary first gate insulating spacers S11 and S12 are formed adjacent to the sidewalls of said dummy gate DG and over the substrate layer SL so that the temporary first gate insulating spacers present two lateral side walls SW1 and SW2 and two outer surface profiles SP1 and SP2 where the lateral side walls meet the substrate layer SL; in a third step, a source region S and a drain region D are formed over the substrate layer SL using the surface profiles of said temporary gate insulating spacers lateral side walls; in a fourth step, a pair of second gate insulating spacers S21 and S22 are formed adjacent to the sidewalls of the temporary first gate insulating spacers S11 and S12 and over the source and drain regions.

According to one embodiment of the invention, as shown in **figures 1A** and **1B****,** the source and drain regions are grown over the substrate layer SL and extend along the temporary first gate insulating spacers lateral side walls surface profiles SP1 and SP2, so that they are aligned to those surface profiles. According to the embodiment of the invention, the temporary first gate insulating spacers S11 and S12 limit the source/drain region extension in the direction of the gate.

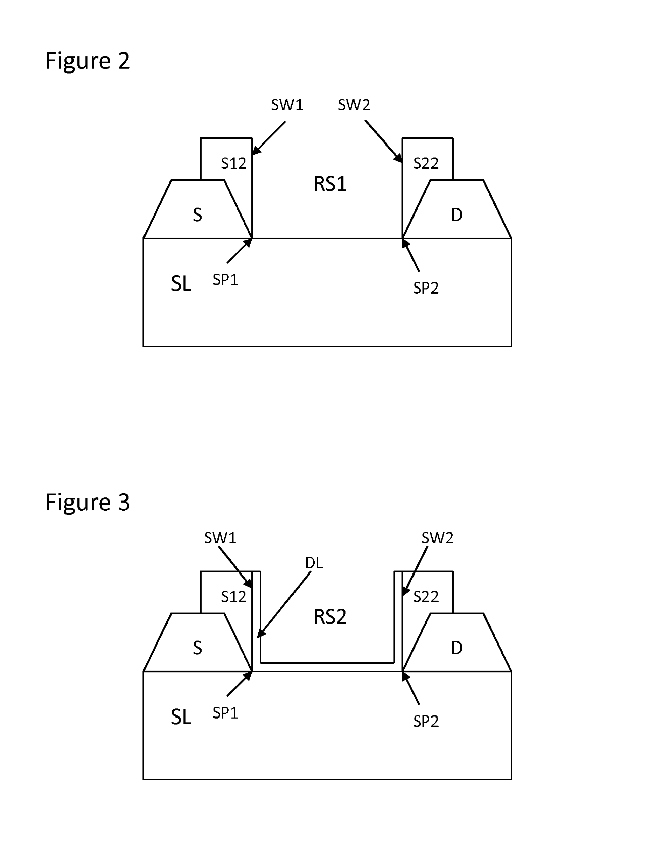

In subsequent steps of manufacture of the field-effect semiconductor device 1 of **figure 4**, the temporary dummy gate DG, the temporary dummy dielectric DD and the temporary first gate insulating spacers S11 and S12 are removed, so as to form a first gate recess space RS1, as shown in **figure 2****.**

In a preferred embodiment according to the invention, the temporary first gate insulating spacers S11 and S12 are made of material different from the material of the temporary dummy gate, and the temporary first gate insulating spacers S11 and S12 are removed after having removed that dummy gate. In that case, more definition control over the first gate recess boundaries close to the second gate insulating spacers S21 and S22 is achieved. It shall be understood that the presence of the temporary dummy dielectric DD under the temporary dummy gate structure DG is optional, and that said dummy dielectric DD may be advantageous to achieve better control definition over the first gate recess boundaries close to the substrate layer. According to another preferred embodiment of the invention, the temporary first gate insulating spacers S11 and S12 are made of a material which allows removing said first gate spacers without substantially removing the material of the second gate insulating spacers S21 and S22, for example, by etching out the material with a selectivity ratio higher than 2 to 1. In one example, the temporary first gate insulating spacers are made of an oxide material and the second gate insulating spacers are made of a dense nitride material. In another example, the temporary first gate insulating spacers are made of a nitride component deposited at temperatures lower than 480 C and designed to etch faster in hydrofluoric acid than the material of the second gate insulating spacers.

Now referring to the **figure 3****,** which shows an embodiment in a subsequent step of manufacture of the field-effect semiconductor device 1 of **figure 4**, a dielectric layer DL is deposited in the first gate recess space RS1, along the side walls of the second gate sidewall insulating spacers S21 and S22 and over the substrate layer SL, so as to form a second gate recess space RS2.

According to a preferred embodiment of the invention, the dielectric layer DL is made of a material with high dielectric constant value. Advantageously, the thickness of said dielectric layer DL can be precisely controlled using atomic layer deposition (ALD) techniques, and in that sense, according to the embodiment of the invention, said dielectric layer thickness defines the distance from the source/drain junctions to the gate electrode edges, shown as a first distance D1, or underlap distance, in **figures 4****,** **6** and **12****.**

Finally, in **figure 4****,** the field-effect semiconductor device 1 according to one embodiment of the invention is formed by depositing a gate electrode GE in said second gate recess space RS2.

**Figure 5** is a cross-sectional view of another embodiment of the invention at an early stage of manufacture, comprising a substrate layer SL, a source region S and a drain region D, a dummy gate DG, a dummy dielectric DD, a pair of first gate insulating spacers S11 and S12 presenting two lateral side walls SW1 and SW2 and two outer surface profiles SP1 and SP2 where the lateral side walls meet the substrate layer SL, and a pair of second gate insulating spacers S21 and S22.

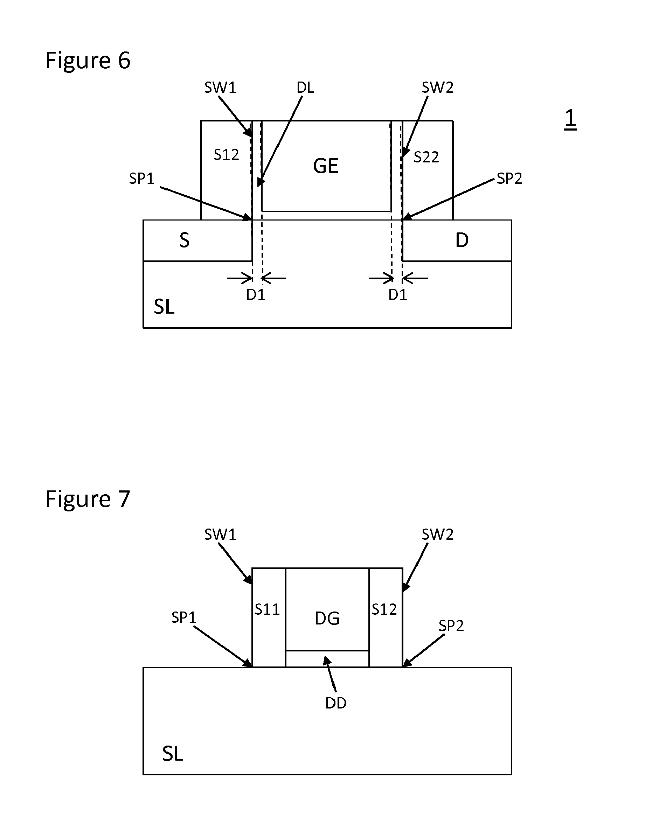

Manufacturing of the field-effect semiconductor device 1 of **figure 6** may begin by forming the embodiment of **figure 5** according to the following: in a first step a temporary dummy dielectric DD and a temporary dummy gate DG are formed over a substrate layer SL; in a second step, a pair of temporary first gate insulating spacers S11 and S12 are formed adjacent to the sidewalls of said dummy gate DG and over the substrate layer SL so that the temporary first gate insulating spacers present two lateral side walls SW1 and SW2 and two outer surface profiles SP1 and SP2 where the lateral side walls meet the substrate layer SL; in a third step, a source region S and a drain region D are formed in the substrate layer SL using the surface profiles of the temporary gate insulating spacers lateral side walls; in a fourth step, a pair of second gate insulating spacers S21 and S22 are formed adjacent to the sidewalls of the temporary first gate insulating spacers S11 and S12 and over the source and drain regions.

According to one embodiment of the invention, as shown in **figure 5**, the source and drain regions are formed in the substrate layer SL and extend along the temporary first gate insulating spacers lateral side walls surface profiles SP1 and SP2. In order to form said source/drain regions, for example, the surface profiles of said temporary gate insulating spacers lateral side walls is used as a mask in order to align said source/drain regions, in the substrate layer, to those surface profiles.

Similarly to the embodiment of **figure 2**, in subsequent steps of manufacture of the field-effect semiconductor device 1 of **figure 6**, the temporary dummy gate DG, the temporary dummy dielectric DD and the temporary first gate insulating spacers S11 and S12 are removed, so as to form a first gate recess space RS1.

Also similarly to the embodiment shown in **figure 3****,** in a subsequent step of manufacture of the field-effect semiconductor device 1 of **figure 6**, a dielectric layer DL is deposited in the first gate recess space RS1, along the side walls of the second gate sidewall insulating spacers S21 and S22 and over the substrate layer SL, so as to form a second gate recess space RS2.

Finally, as shown in **figure 6**, the field-effect semiconductor device 1 according to one embodiment of the invention is formed by depositing a gate electrode GE in said second gate recess space RS2.

It shall be understood that the embodiment of **figure 6** differs from the embodiment of **figure 4** in the position of the source and drain regions, but a similar purpose according to the invention is achieved, so as to align the source/drain regions to the surface profiles of the temporary first gate insulating spacers lateral side walls SW1 and SW2 in order to precisely control the underlap distance D1.

**Figure 7** shows a cross-sectional view of another embodiment of the invention at an early stage of manufacture, comprising a substrate layer SL, a dummy gate DG, a dummy dielectric DD and a pair of first gate insulating spacers S11 and S12 presenting two lateral side walls SW1 and SW2 and two outer surface profiles SP1 and SP2 where the lateral side walls meet the substrate layer SL.

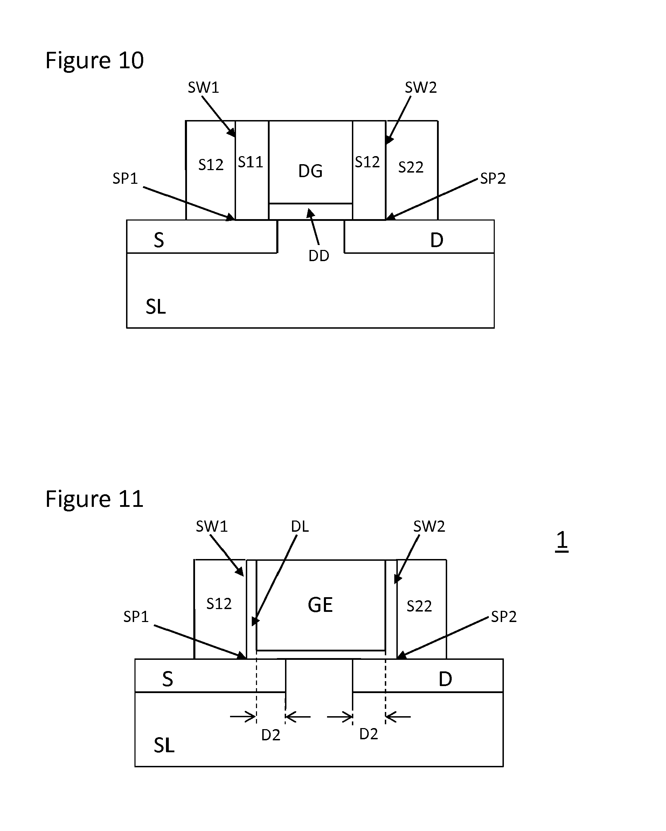

Manufacturing of the field-effect semiconductor device 1 of **figure 11** may begin by forming the embodiment of **figure 7** according to the following: in a first step, a temporary dummy dielectric DD and a temporary dummy gate DG are formed over a substrate layer SL; in a second step, a pair of temporary first gate insulating spacers S11 and S12 are formed adjacent to the sidewalls of said dummy gate DG and over the substrate layer SL so that the temporary first gate insulating spacers present two lateral side walls SW1 and SW2 and two outer surface profiles SP1 and SP2 where the lateral side walls meet the substrate layer SL.

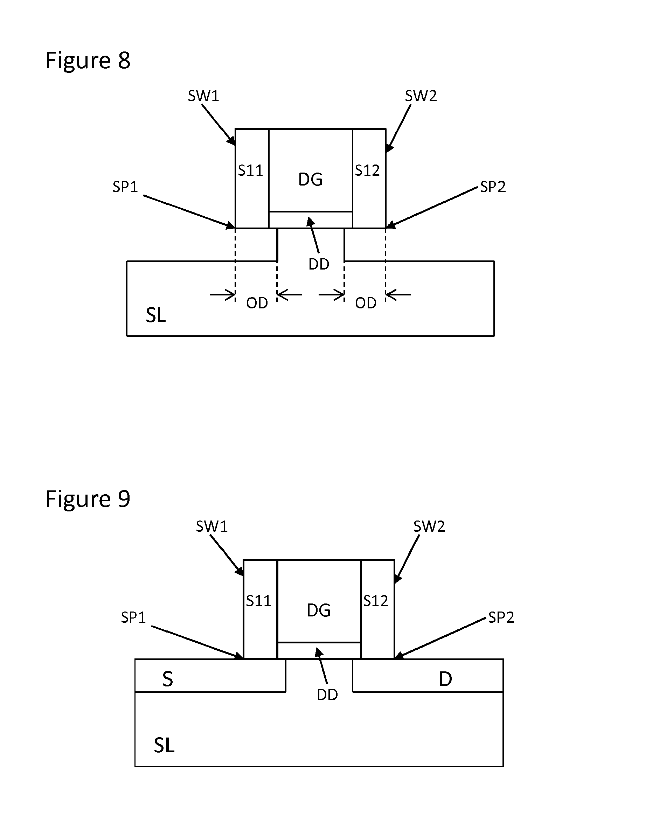

In subsequent steps of manufacture of the field-effect semiconductor device 1 of **figure 11**, an opening, extending from the surface profiles SP1 and SP2 to a predetermined distance OD in the direction of the dummy gate DG, is formed in the substrate layer SL, as shown in **figure 8**, and the opening follows or presents the same surface profile of the temporary first gate insulating spacers lateral side walls surface profile SP1 and SP2 under the dummy gate DG (when seen from a top view of the FET device).

Referring next to the **figure 9**, which shows an embodiment in a subsequent step of manufacture of the field-effect semiconductor device 1 of **figure 11**, the openings are filled so as to form a source region S and a drain region D in the substrate layer SL. Then, in **figure 10****,** a pair of second gate insulating spacers S21 and S22 are formed adjacent to the sidewalls of the temporary first gate insulating spacers S11 and S12 and over the source and drain regions.

Similarly to the embodiment of **figure 2**, in subsequent steps of manufacture of the field-effect semiconductor device 1 of **figure 11**, the temporary dummy gate DG, the temporary dummy dielectric DD and the temporary first gate insulating spacers S11 and S12 are removed, so as to form a first gate recess space RS1.

Also similarly to the embodiment shown in **figure 3****,** in a subsequent step of manufacture of the field-effect semiconductor device 1 of **figure 11**, a dielectric layer DL is deposited in the first gate recess space RS1, along the side walls of the second gate sidewall insulating spacers S21 and S22 and over the substrate layer SL, so as to form a second gate recess space RS2. Then, in a final step, the field-effect semiconductor device 1 of **figure 11** according to one embodiment of the invention is formed by depositing a gate electrode GE in said second gate recess space RS2.

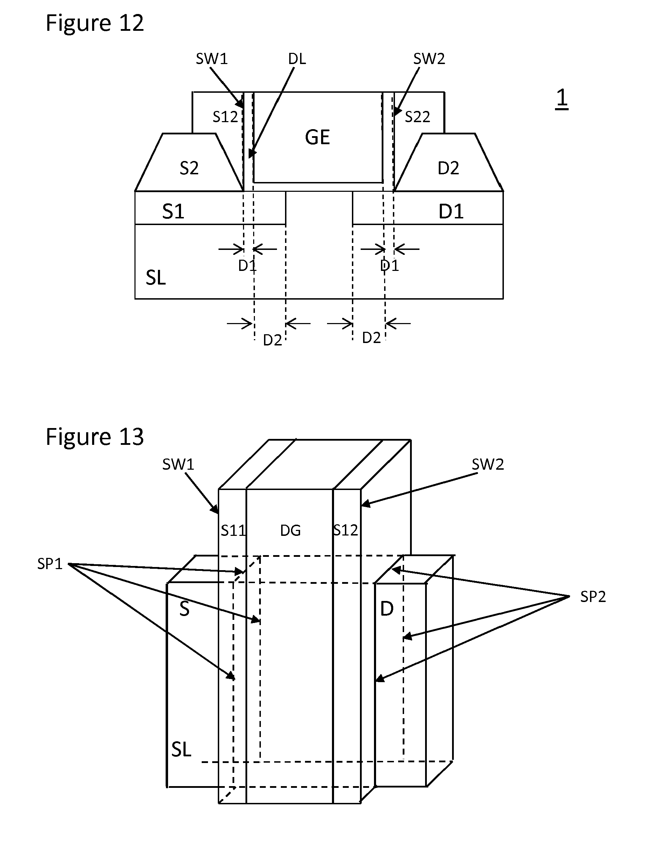

According to an embodiment of the invention, as shown in **figure 11**, the source and drain regions extend to a predetermined distance, OD in **figure 8**, from an early defined surface profile SP1 and SP2 of the temporary first gate insulating spacers lateral side walls towards the gate electrode GE, and the source and drain regions follow the surface profile of the temporary first gate insulating spacers lateral side walls SW1 and SW2 under the gate electrode. Advantageously, since both the thickness of the dielectric layer DL and the extension of the source/drain regions can be precisely controlled, both parameters can be used to precisely control a distance from the source/drain junctions under the gate electrode to the gate electrode edges, shown as a second distance D2, or overlap distance, in **figures 11** and **12****.**

Figure 12 shows a cross-sectional view of another embodiment of a field-effect semiconductor device 1 according to the invention at a final stage of manufacture, comprising a substrate layer SL, a first and a second source regions S1 and S2, a first and a second drain regions D1 and D2, a dielectric layer DL, a gate electrode GE and a pair of second gate insulating spacers S21 and S22.

It is understood by the person skilled in the art that the embodiment of **figure 12** is manufactured similarly to the embodiment shown in **figure 11**, but further comprising second source and drain regions formed over the substrate layer which are aligned using a surface profile of the temporary gate insulating spacers lateral side walls SW1 and SW2 similarly to the embodiment shown in **figure 4****.**

**Figure 13** is a simplified and schematic 3D view of a non-planar field-effect semiconductor device, such as FinFET, according to one embodiment of the invention, at an early stage of manufacture, comprising a FIN substrate layer SL, a source region S and a drain region D formed in said FIN substrate layer, a dummy gate DG, a first pair of gate insulating spacers S11 and S12 presenting two lateral side walls SW1 and SW2 in the length direction of the field-effect semiconductor device channel and two outer surface profiles SP1 and SP2 (along 3 FIN walls: front, top and back walls, as shown in the figure) where the temporary first gate insulating spacers lateral side walls SW1 and SW2 meet the FIN substrate layer SL. The embodiment shown in the figure is similar to the planar embodiment of **figure 5** but at a stage previous to forming the second gate insulating spacers S21 and S22.

It shall be understood that the person skilled in the art will readily be able to advantageously apply the aspects of the invention described hereinabove in a non-planar implementation of a FET device, in order to precisely control the source/drain-gate overlap/underlap distance along the FIN walls.

## Claims

1. A method for manufacturing a field-effect semiconductor device (1) comprising:
- forming a temporary dummy gate (DG) over a substrate layer (SL);
- forming temporary first gate insulating spacers (S11, S12) adjacent to the sidewalls of said dummy gate (DG) and over the substrate layer (SL), the temporary first gate insulating spacers comprising two lateral side walls (SW1, SW2) and presenting two outer surface profiles (SP1, SP2) where said lateral side walls meet said substrate layer (SL);
- forming a source region (S) and a drain region (D) in and/or over the substrate layer (SL) using said temporary first gate insulating spacers lateral side walls surface profiles (SP1, SP2);
- forming second gate insulating spacers (S21, S22) adjacent to the sidewalls of said temporary first gate insulating spacers (S11, S12) and over the source and drain regions (S, D);
- removing the temporary dummy gate (DG) and the temporary first gate insulating spacers (S11, S12), thereby forming a first gate recess space (RS1);
- depositing a dielectric layer (DL) in said first gate recess space (RS1), along the side walls of the second gate sidewall insulating spacers (S21, S22) and over the substrate layer (SL), thereby forming a second gate recess space (RS2); and
- depositing a gate electrode (GE) in said second gate recess space (RS2).

2. The method according to claim 1 wherein the step of forming a source region (S) and a drain region (D) comprises using said surface profiles (SP1, SP2) of said temporary first gate insulating spacers lateral side walls (SW1, SW2) to align said source/drain regions, in or over the substrate layer, to said surface profiles.

3. The method according to claim 1 wherein the step of forming a source region (S) and a drain region (D) comprises using said surface profiles (SP1, SP2) of said temporary first gate insulating spacers lateral side walls (SW1, SW2) to define said source/drain region extension, in the substrate layer, under the dummy gate (DG).

4. The method according to claim 1 wherein the step of forming a source region (S) and a drain region (D) comprises using said surface profiles (SP1, SP2) of said temporary first gate insulating spacers lateral side walls (SW1, SW2) to align said source/drain regions, over the substrate layer, to said surface profiles and to define said source/drain region extension, in the substrate layer, under the dummy gate (DG).

5. The method according to any of the preceding claims wherein the temporary first gate insulating spacers (S11, S12) are removed after the temporary dummy gate removal, thereby forming a first gate recess space (RS1);

6. The method according to any of the preceding claims further comprising forming a temporary dummy dielectric (DD) between the dummy gate (DG) and the substrate layer (SL), and wherein the step of removing the temporary dummy gate (DG) and the temporary first gate insulating spacers (S11, S12) comprises also removing the dummy dielectric (DD), thereby forming the first gate recess space (RS1).

7. The method according to any of the preceding claims wherein the step of removing the temporary first gate insulating spacers (S11, S12) comprises selectively removing the material of the temporary first gate insulating spacers without substantially removing the material of the second gate insulating spacers (S21, S22).

8. The method according to claim 7 wherein the temporary first gate insulating spacers (S11, S12) are made of an oxide material and the second gate insulating spacers (S21, S22) are made of a dense nitride material.

9. The method according to claim 7 wherein the temporary first gate insulating spacers (S11, S12) are made of a nitride component deposited at temperatures lower than 480 C and designed to etch faster in hydrofluoric acid than the material of the second gate insulating spacers (S21, S22).

10. The method according to any of the previous claims wherein the substrate layer (SL) comprises at least one silicon wafer layer; or at least a silicon wafer layer and a quantum well layer; or at least a silicon wafer layer, a buried oxide layer and a silicon layer.
